# EUROPÄISCHE PATENTSCHRIFT

(11) **EP 3 293 814 B1**
(45) Veröffentlichungstag und Bekanntmachung des Hinweises auf die Patenterteilung: **29.04.2020**
(21) Anmeldenummer: 16188539.7
(22) Anmeldetag: 13.09.2016
(51) Int. Cl.: H01P 3/12, H01Q 23/00, H05K 1/02, H01L 23/66, H01P 5/107, H01Q 13/06, H01L 23/538

(54) **SCHALTUNGSSUBSTRAT UND ELEKTRONISCHES HÖCHSTFREQUENZ-BAUTEIL**
CIRCUIT SUBSTRATE AND ELECTRONIC SUPER HIGH FREQUENCY COMPONENT
SUBSTRAT DE CIRCUIT ET COMPOSANT ELECTRONIQUE HAUTE FREQUENCE

(43) Veröffentlichungstag der Anmeldung: 14.03.2018
(73) Patentinhaber: Dyconex AG, 8303 Bassersdorf (CH)
(72) Erfinder: Bihler, Eckardt, 8406 Winterthur (CH); Hauer, Marc, 8610 Uster (CH); Schulze, Daniel, 8303 Bassersdorf (CH)
(74) Vertreter: Galander, Marcus

(56) Entgegenhaltungen:
- EP-A1- 2 958 188
- WO-A1-2007/149046
- WO-A1-2016/016968
- DE-T5-112006 003 543
- US-A1- 2003 107 459
- US-A1- 2009 322 643
- US-A1- 2012 119 932
- Markus Leitgeb: "High End PCBs Empowering your products with new integration concepts and novel applications", , 1 March 2013 (2013-03-01), pages 1-33, XP055304389, Retrieved from the Internet: URL:http://www.ats.net/wp-content/uploads/ 2013/03/High-End-PCBs_Oulu_2013_handout.pd f [retrieved on 2016-09-21]

## Beschreibung

Die Erfindung betrifft ein Schaltungssubstrat eines elektronischen Höchstfrequenz-Bauteils, welches auf einem organischen Substratmaterial aufgebaut ist. Sie betrifft des Weiteren ein Höchstfrequenz-Bauteil mit einem solchen Schaltungssubstrat.

Hohlleiter sind an sich bekannt. Sie finden Einsatz als elektrische Leitungen für höchste Frequenzen oberhalb von 10 GHz. Gegenüber anderen bekannten elektrischen Verbindungen, wie z. B. Koaxialkabeln, weisen Hohlleiter die geringsten Verluste auf, da sie kein verlustbehaftetes Dielektrikum enthalten. Die verbleibenden Verluste in Hohlleitern werden durch die in den metallischen Wänden des Hohlleiters entstehenden Abschirmströme verursacht. Hohlleiter werden aus Metall hergestellt. Je besser die Leitfähigkeit des Metalls, desto geringer sind die Verluste.

In Schaltungssubstraten, insbesondere Leiterplatten, die zur Verbindung von Komponenten mit hochfrequenten Signalen verwendet werden, finden beim Stand der Technik Streifen- bzw. Mikrostrip-Leitungen oder andere Wellenleiterstrukturen Verwendung. Kennzeichnend für diese in Substraten eingebetteten Wellenleiter ist, dass immer ein Dielektrikum (das Substratmaterial) vorhanden ist, das den Raum zwischen den Strom führenden Leitern ausfüllt. Sollen Hohlleiter möglichst verlustfrei mit Substraten verbunden werden, müssen die Hohlleiter mit den Substraten möglichst gut elektrisch verbunden werden. Das geschieht z. B. durch Verlöten des Hohlleiters mit Pads auf dem Substrat. Das ist auch die Lösung, wie sie in US 8,669,834 B2 oder in WO 2013/017844 A1 beschrieben wird. Weiterhin sind aus der US 2003/0107459 A1 ein Funkfrequenzmodul bekannt, das ein rechteckförmiges Durchgangsloch in einem dielektrischen Substrat aufweist. Schließlich offenbart die WO 2007/149046 A1 eine quasi-planare Schaltung mit einer Vielzahl an Platinen auf, von denen zumindest eine eine Luftkavität aufweist. Die WO 2016/016968 A1 offenbart einen in mehrere Substratlagen eingebetteten Hohlleiter, der durch eine aktive integrierte Schaltung, die ebenfalls in das Substrat eingebettet ist, gespeist wird.

Der Erfindung liegt die Aufgabe zugrunde, ein hinsichtlich seiner elektrischen Eigenschaften bezüglich höchstfrequenter Signale verbessertes und relativ einfach und kostengünstig herstellbares Schaltungssubstrat der o. g. Art bereitzustellen. Weiterhin soll ein in ähnlicher Weise verbessertes elektronisches Höchstfrequenz-Bauteil angegeben werden.

Diese Aufgabe wird durch ein Schaltungssubstrat mit den Merkmalen des Anspruchs 1 gelöst. Zweckmäßige Ausführungsformen der Erfindung sind Gegenstand der abhängigen Ansprüche.

Die Erfindung schließt den Gedanken einer direkten Kombination zwischen organischem Schaltungssubstrat (in Art herkömmlicher Leiterplatten) und herkömmlichem Hohlleiter ein. Sie schließt weiterhin den Gedanken ein, einen solchen Hohlleiter unmittelbar in das organische Schaltungssubstrat einzubetten, und zwar als einen an seinen Begrenzungsflächen mindestens teilweise mit einer Metallschicht versehenen Hohlraum. Schließlich gehört zur Erfindung der Gedanke, diesen (mindestens teilweise metallisierten) Hohlraum direkt an eine aktive Bauteilkomponente angrenzend und hierbei direkt mit dieser elektrisch verbunden anzuordnen oder eine Signalverbindung mit der Komponente durch eine in den Hohlraum ragende metallische Zuleitung, insbesondere Streifenleitung, zu realisieren.

Durch die Erfindung ist die Herstellung von komplett mit allen notwendigen Komponenten integrierten Substraten für Millimeterwellen möglich. Durch die kürzeren Abstände zu den integrierten Hohlleitern können Dämpfungen reduziert und die Effizienz gegenüber vorbekannten Lösungen verbessert werden. Gleichzeitig werden niedrigere Herstellkosten erwartet, was dem Hersteller beim Verkauf bessere Margen und ein Alleinstellungsmerkmal im Markt für Millimeterwellen-Anwendungen verschafft.

In einer aus derzeitiger Sicht bevorzugten Ausführung des Schaltungssubstrats weist das Substratmaterial ein flüssigkristallines Polymer, LCP, auf. In weiteren Ausführungen hat das Schaltungssubstrat einen mehrschichtigen Aufbau, der mindestens zwei Substratmaterial-Lagen mit einer dazwischenliegenden strukturierten Metallschicht, insbesondere Kupferschicht, umfasst. In einer Kombination mit der vorgenannten bevorzugten Materialwahl ist vorgesehen, dass eine erste Substratmaterial-Lage als LCP-Leiterplatte mit beidseitiger Kupferbeschichtung und eine zweite Substratmaterial-Lage als gegenüber der ersten Substratmaterial-Lage dünnere und niedriger schmelzende LCP-Folie ausgeführt ist. Weitere Lagen zum Ausgleich erforderlicher Bauteilhöhenunterschiede sind ebenfalls möglich.

In weiteren Ausgestaltungen hat das Schaltungssubstrat mindestens eine weitere strukturierte Metallschicht, insbesondere als Deckschicht. Speziell ist vorgesehen, dass die als Deckschicht angeordnete weitere Metallschicht mindestens einen Abschnitt des oder jedes als Hohlleiter wirkenden Hohlraums abdeckt.

In weiteren zweckmäßigen Ausführungen hat der Hohlraum mindestens in einer zur Substratebene senkrechten Schnittfläche, insbesondere in zwei zur Substratebene und zueinander senkrechten Schnittflächen, rechteckige Gestalt. Der Hohlraum ist insbesondere so konfiguriert, dass eine erste Seite der oder mindestens einer Schnittfläche eine Länge im Bereich zwischen 1 und 4 mm, insbesondere zwischen 1,5 und 3 mm, und eine zweite Seite dieser Schnittfläche eine Länge zwischen 1 und 7 mm, insbesondere zwischen 2 und 5 mm, hat. Wenn der Hohlraum grabenförmig langgestreckt ist, richtet sich seine Länge nach der Anordnung der zu verbindenden aktiven Bauteilkomponenten und ggfs. nach einer Seitenlänge des Schaltungssubstrats.

In einer weiteren Ausführung ist der Hohlraum an mindestens einem Ende offen, derart, dass er als Antenne für höchstfrequente Signale wirkt. Insbesondere kann der Hohlraum bis zu einer Begrenzungskante des Schaltungssubstrats reichen und dort offen sein, d. h. als Antenne wirken. Unabhängig hiervon kann in mindestens einer ansonsten geschlossenen Begrenzungsfläche, etwa der Boden- oder Deckfläche, des Hohlleiters mindestens eine Öffnung zur Ausstrahlung höchstfrequenter Signale vorgesehen sein. Speziell können eine oder mehrere Ausstrahlungs-Öffnungen in einer Bodenfläche oder Deckfläche des Hohlraums, insbesondere in einer nicht von organischem Substratmaterial umgebenen Begrenzungsfläche, angeordnet sein.

In aus derzeitiger Sicht zweckmäßiger Weise sind in einer weiteren Ausführung alle Begrenzungsflächen im Wesentlichen vollständig mit einer Metallschicht bedeckt. Falls jedoch zur Verbindung mit einer oder mehreren aktiven Komponente(n) zusätzliche Zuleitungen vorgesehen sind, ist die Metallschicht um einen Durchstoßpunkt einer oder jeder in den Hohlraum ragenden metallischen Zuleitung entfernt, derart, dass die oder jede Zuleitung gegenüber der Metallschicht elektrisch isoliert ist.

Für eine optimale Funktion des Hohlleiters ist, wie eingangs der Beschreibung erwähnt, die Leitfähigkeit der seine Begrenzungsflächen bildenden Metallisierung wichtig. Aufgrund des Skineffektes spielt primär die unmittelbar an der Oberfläche liegende Schicht eine Rolle. Daher ist in vorteilhaften Ausgestaltungen vorgesehen, dass die Metallisierung oder zumindest deren Oberflächenschicht aus einem hoch leitfähigen und korrosionsbeständigen Metall, wie etwa Gold oder Silber, besteht. Hingegen kann eine Basisschicht der Metallisierung und sogar deren weitaus größter Teil auch aus einem Metall niedrigerer Leitfähigkeit bestehen.

Vorteile und Zweckmäßigkeiten der Erfindung ergeben sich im Übrigen aus der nachfolgenden Beschreibung von Ausführungsbeispielen anhand der Figuren. Von diesen zeigen:
- Fig. 1: eine schematische Querschnittsdarstellung eines Schaltungssubstrats gemäß einem ersten Beispiel zum Verständnis der Erfindung,
- Fig. 2: eine schematische Querschnittsdarstellung eines Schaltungssubstrats gemäß einem zweiten Beispiel zum Verständnis der Erfindung,
- Fig. 3: eine schematische Querschnittsdarstellung eines Schaltungssubstrats gemäß einer ersten Ausführungsform der Erfindung,
- Fig. 4: eine schematische perspektivische Darstellung eines beispielhaften Höchstfrequenz-Bauteils zum Verständnis der Erfindung.

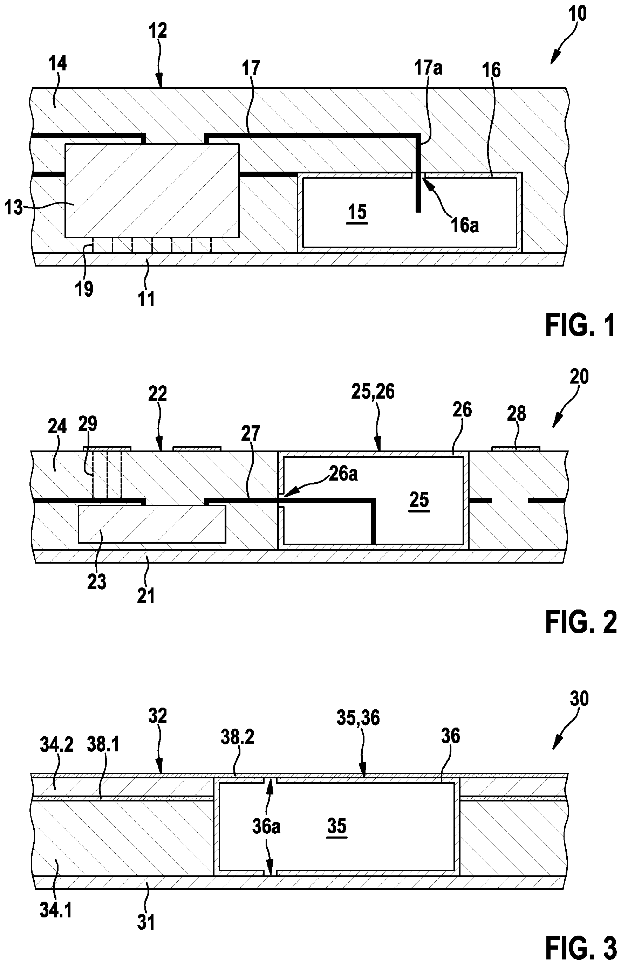

Fig. 1 zeigt als schematische Querschnittsdarstellung einen Schnitt durch ein elektronisches Bauteil bzw. eine Baugruppe 10, in der höchstfrequente Signale mit einer Trägerfrequenz von über 10 GHz übertragen und verarbeitet werden. Auf einer beispielsweise aus Kupfer bestehenden Grundplatte 11 eines im Wesentlichen aus einem LCP gebildeten Schaltungssubstrats 12 ist eine Bauteilkomponente 13 unter Einbettung in eine dicke LCP-Schicht 14 fixiert. Um die Bauteilkomponente thermisch und elektrisch an die Grundplatte 11 anzubinden, können optional mit Kupfer gefüllte Durchkontaktierungen 19 eingefügt werden. Mit etwas Abstand neben der Bauteilkomponente 13 befindet sich ein Hohlraum 15 mit rechteckigem Querschnitt, dessen Umfangswände sämtlich vollständig mit einer Metallschicht 16 bedeckt sind - mit Ausnahme eines kleinen Bereiches 16a der Deckfläche. Hier ragt ein Durchkontaktierungs-Abschnitt 17a einer Mikrostrip-Zuleitung 17 in den Hohlraum 15.

In den Hohlraum wird über einen (nicht dargestellten) Einkopplungsabschnitt ein höchstfrequentes Signal eingekoppelt, welches sich im Hohlraum ausbreitet, wodurch dieser als Hohlleiter 15/16 wirkt. Über den Durchkontaktierungsableger 17a wird die im Hohlleiter 15/16 fortgeleitete Höchstfrequenz-Signalwelle in die Mikrostrip-Zuleitung 17 eingekoppelt und zur aktiven Bauteilkomponente 13 übertragen. Die aktive Bauteilkomponente kann im Übrigen über Durchkontaktierungen 19 mit der Grundplatte 11 verbunden sein.

Fig. 2 zeigt eine zum Bauteil 10 nach Fig. 1 weitgehend ähnliches Beispiel zum Verständnis der Erfindung, nämlich ein Bauteil 20, welches ebenfalls ein LCP-Schaltungssubstrat 22 mit einer Grundplatte 21 und einer LCP-Schicht 24 sowie einen an seinen Umfangswänden nahezu vollflächig mit einer Metallbeschichtung 26 versehenen Hohlraum 25 umfasst, der zusammen mit der Metallbeschichtung einen Hohlleiter 25/26 bildet.

Im Unterschied zum Bauteil nach Fig. 1 mündet die auch hier vorgesehene Mikrostrip-Zuleitung 27 der Bauteilkomponente 23 nicht an der Deckfläche, sondern an einer Seitenfläche des Hohlleiters 25/26 in diesen. Dort gibt es wiederum eine Unterbrechung 25a der Metallbeschichtung 26, ähnlich wie beim Hohlleiter 15/16 nach Fig. 1 in der Deckfläche. Die Zuordnung zwischen Hohlleiter 25/26 und Mikrostrip-Zuleitung 27 nach Fig. 2 bewirkt die Einkopplung der transversalen magnetischen Signalwellen-Mode in den Hohlleiter bzw. deren Auskopplung aus dem Hohlleiter, während bei der Anordnung nach Fig. 1 eine Ein- bzw. Auskopplung der transversalen elektrischen Wellen-Mode erfolgt.

Ein weiterer Unterschied zur Anordnung nach Fig. 1 besteht darin, dass auf der Oberfläche der LCP-Schicht 24 eine strukturierte Metallisierung 28, beispielsweise aus Kupfer oder Aluminium, vorgesehen ist, um weitere elektrische Verbindungen innerhalb des Bauteils 20 zu realisieren. Die metallische Schicht, die den Hohlraum 25 abdeckt, kann hierbei als Teil jener strukturierten Metallschicht 28 realisiert sein. Die strukturierte Metallschicht 28 kann auch über Durchkontaktierungen 29 mit der Mikrostrip-Leitung 27 verbunden sein und als Antennenfläche (z. B. für eine Patch Antenne) ausgeformt sein.

Fig. 3 zeigt, wiederum in einer den Figuren 1 und 2 ähnlichen Querschnittsdarstellung, einen Ausschnitt eines weiteren Höchstfrequenz-Bauteils 30, welches mit einem Schaltungssubstrat 32 aufgebaut ist, das einen Zweischicht-Aufbau aus einer ersten, dickeren und höher schmelzenden LCP-Schicht 34.1 auf einer Grundplatte 31 und einem über diese gelegten dünnen, niedriger schmelzenden LCP-Folie 34.2, umfasst. Zwischen den beiden LCP-Schichten 34.1 und 34.2 ist eine Zwischenschicht-Metallisierung 38.1 angeordnet, und auf der Oberfläche des Schaltungssubstrats ist eine Deckschicht-Metallisierung 38.2 angeordnet.

In das Schaltungssubstrat 32 ist wiederum ein Hohlleiter 35/36 eingebettet, der aus einem im Querschnitt rechteckigen Graben 35 und einer Metallisierung 36 besteht, welche den Boden und die Seitenwände des Grabens und auch dessen Oberseite nahezu vollständig bedeckt. In Fig. 3 sind beispielhaft sowohl in der Bodenfläche als auch in der Deckfläche je eine Höchstfrequenz-Ein-Auskopplungsöffhung 36a dargestellt.

Eine aktive Bauteilkomponente ist in Fig. 3 ebenso wenig dargestellt wie eine Zuleitung zu einer solchen: derartige Komponenten können aber vorgesehen sein, und die Zuleitungen können beispielsweise durch eine Strukturierung der Metallschichten 38.1, 38.2 realisiert werden. Im Übrigen müssen aktive Bauteilkomponenten nicht notwendigerweise (wie in Fig. 1 und 2 dargestellt) in das jeweilige Schaltungssubstrat eingebettet sein, sondern sie können auch auf dieses aufgesetzt oder ggfs. auch unterhalb desselben angeordnet sein.

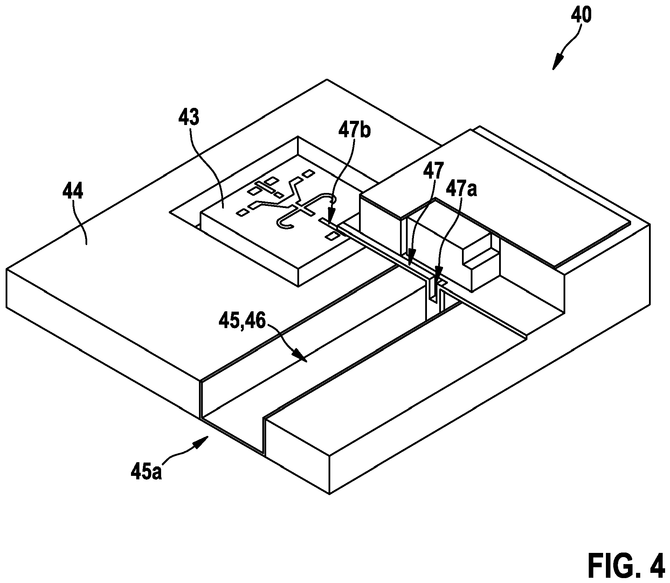

Fig. 4 zeigt in einer perspektivischen schematischen Darstellung ein weiteres elektronisches Bauteil 40, dessen Teile wiederum in Anlehnung an die anderen Figuren mit Ziffern bezeichnet sind. Es umfasst ein Schaltungssubstrat 44 (dessen Aufbau hier nicht genauer gezeigt ist) mit einer eingebetteten aktiven Bauteilkomponente 43 und einem langgestreckten Hohlleiter 45/46. Der Hohlleiter 45/46 hat an einer Kante des Schaltungssubstrats 44 ein offenes Ende 45a, das als Antenne zur Ein- oder Auskopplung von höchstfrequenten Signale und eine begrenzende Fläche des Hohlleiters wirkt.

Wiederum ist eine Mikrostrip-Leitung 47 zur Herstellung einer Signalverbindung zwischen der aktiven Bauteilkomponente 43 und dem Hohlleiter 45/46 vorgesehen. Diese hat auch wieder einen in den Hohlraum des Hohlleiters ragenden Durchkontaktierungs(Via)-Abschnitt 47a, der zur Einkopplung des höchstfrequenten Signals aus der Mikrostrip-Leitung 47 über die transversale magnetische Wellenmode in den Hohlleiter dient (gleichartig wie in Fig. 2 dargestellt). Ein weiterer Via-Abschnitt 47b der Zuleitung bzw. Verbindungsbrücke 47 dient der Kontaktierung der Bauteilkomponente 43.

Zu Details der möglichen Ausführungen des Schaltungssubstrats und des eingebetteten Hohlleiters unter Material- oder Dimensionierungs-Aspekten wird auf die allgemeinen Ausführungen weiter oben verwiesen

Die Ausführung der Erfindung ist nicht auf die oben beschriebenen Beispiele und Aspekte beschränkt, sondern ebenso in einer Vielzahl von Abwandlungen möglich, die im Rahmen des Schutzumfangs der angehängten Ansprüche liegen.

## Patentansprüche

1. Schaltungssubstrat (12; 22; 32; 42) eines elektronischen Höchstfrequenz-Bauteils (10; 20; 30; 40), aufweisend
ein organisches Substratmaterial (14; 24; 34; 44),
eine aktive Bauteilkomponente (13; 23; 43), und
mindestens einen in das Substratmaterial eingearbeiteten, an den Begrenzungsflächen mindestens teilweise mit einer Metallschicht (16) versehenen und als Hohlleiter (15/16; 25/26; 35/36; 45; 46) für elektrische Signale mit einer Trägerfrequenz von 10 GHz oder mehr wirkenden Hohlraum (15), der direkt an die aktive Bauteilkomponente (13; 23; 43) angrenzt und hierdurch oder über eine in den Hohlraum ragende metallische Zuleitung (17; 27; 47) mit der aktiven Bauteilkomponente (13; 23; 43) elektrisch verbunden ist, wobei das Substrat einen mehrschichtigen Aufbau aufweist, der mindestens zwei Substratmaterial-Lagen (34.1; 34.2) mit einer dazwischenliegenden strukturierten Metallschicht (38.1) umfasst, und **dadurch gekennzeichnet, dass** eine erste Substratmaterial-Lage als flüssigkristalline Polymer-Leiterplatte, LCP-Leiterplatte, (34.1) mit beidseitiger Kupferbeschichtung und eine zweite Substratmaterial-Lage als gegenüber der ersten Substratmaterial-Lage dünnere und niedriger schmelzende flüssigkristalline PolymerFolie, LCP-Folie, (34.2) ausgeführt ist.

2. Schaltungssubstrat (12; 22; 32; 42) nach Anspruch 1, wobei die Zuleitung (17; 27; 47) eine Streifenleitung ist.

3. Schaltungssubstrat (12; 22; 32; 42) nach Anspruch 1 oder 2, wobei der Hohlraum (15; 25; 35; 45) mindestens in einer zur Substratebene senkrechten Schnittfläche, insbesondere in zwei zur Substratebene und zueinander senkrechten Schnittflächen, rechteckige Gestalt hat.

4. Schaltungssubstrat (12; 22; 32; 42) nach Anspruch 3, wobei eine erste Seite der oder mindestens einer Schnittfläche des Hohlraumes (15; 25; 35; 45) eine Länge im Bereich zwischen 1 und 4 mm, insbesondere zwischen 1,5 und 3 mm, und eine zweite Seite dieser Schnittfläche eine Länge zwischen 1 und 7 mm, insbesondere zwischen 2 und 5 mm, hat.

5. Schaltungssubstrat (12; 22; 32; 42) nach einem der vorangehenden Ansprüche, wobei der Hohlraum (45) an mindestens einem Ende (45a) offen ist, derart, dass er als Antenne für höchstfrequente Signale wirkt.

6. Schaltungssubstrat (12; 22; 32; 42) nach einem der vorangehenden Ansprüche, wobei in mindestens einer ansonsten geschlossenen Begrenzungsfläche (36) des Hohlraums (35) mindestens eine Öffnung (36a) zur Ausstrahlung höchstfrequenter Signale vorgesehen ist.

7. Schaltungssubstrat (12; 22; 32; 42) nach einem der vorangehenden Ansprüche, wobei alle Begrenzungsflächen im Wesentlichen vollständig mit einer Metallschicht (16; 26; 36; 46) bedeckt sind.

8. Schaltungssubstrat (12; 22; 32; 42) nach Anspruch 7, wobei die Metallschicht um einen Durchstoßpunkt einer oder jeder in den Hohlraum (15; 25) ragenden metallischen Zuleitung entfernt ist, derart, dass die oder jede Zuleitung (17; 27) gegenüber der Metallschicht (16; 26) elektrisch isoliert ist.

9. Schaltungssubstrat (12; 22; 32; 42) nach einem der vorangehenden Ansprüche, wobei die Metallschicht (16; 26; 36; 46) mindestens an der dem Hohlraum (15; 25; 35; 45) zugewandten Oberfläche Silber oder Gold oder eine Legierung aus diesen aufweist.

10. Schaltungssubstrat (12; 22; 32; 42) nach einem der vorangehenden Ansprüche, wobei die Metallschicht (16; 26; 36; 46) an einer dem Substratmaterial zugewandten Oberfläche Kupfer aufweist.

11. Schaltungssubstrat (22; 32) nach einem der vorherigen Ansprüche, mit mindestens einer weiteren strukturierten Metallschicht (28; 38.2), insbesondere als Deckschicht des Substrats.

12. Schaltungssubstrat (22; 32) nach Anspruch 11, wobei die als Deckschicht angeordnete weitere Metallschicht (28; 38.2) mindestens einen Abschnitt des oder jedes als Hohlleiter (25/26; 35/36) wirkenden Hohlraums (25; 35) abdeckt.

## Claims

1. A circuit substrate (12; 22; 32; 42) of a maximun frequency electronic component (10; 20; 30; 40), comprising:
an organic substrate material (14; 24; 34; 44);
an active component part (13; 23; 43); and
at least one hollow space (15) incorporated into the substrate material, the hollow space being provided, on at least part of its delimiting surfaces, with a metal layer (16) and acting as a waveguide (15/16; 25/26; 35/36; 45; 46) for electrical signals with a carrier frequency of 10 GHz or higher, and being directly adjacent to the active component part (13; 23;43), and thereby being electrically connected to the active component part (13; 23; 43), or being electrically connected to it by means of a metal feed line (17; 27; 47) projecting into the hollow space,
wherein
the substrate has a multilayer structure that comprises at least two substrate material layers (34.1; 34.2) with a structured metal layer (38.1) between them, and
**characterised in that**
a first substrate material layer is embodied as a liquid-crystal polymer circuit board, or LCP circuit board, (34.1) with a copper coating on both sides, and a second substrate material layer is embodied as a liquid-crystal polymer film, or LCP film, (34.2) that is thinner and lower-melting than the first substrate material layer.

2. The circuit substrate (12; 22; 32; 42) according to claim 1, wherein the feed line (17; 27; 47) is a strip line.

3. The circuit substrate (12; 22; 32; 42) according to claim 1 or 2, wherein the hollow space (15; 25; 35; 45) has a rectangular shape, at least in one cut surface perpendicular to the plane of the substrate, especially in two cut surfaces perpendicular to the plane of the substrate and to one another.

4. The circuit substrate (12; 22; 32; 42) according to claim 3, wherein a first side of the cut surface, or of at least one cut surface, of the hollow space (15; 25; 35; 45) has a length in the range between 1 and 4 mm, in particular between 1.5 and 3 mm, and a second side of this cut surface has a length between 1 and 7 mm, in particular between 2 and 5 mm.

5. The circuit substrate (12; 22; 32; 42) according to any one of the preceding claims, wherein the hollow space (45) is open, at least at one end (45a), in such a way that the hollow space acts as an antenna for maximum frequency signals.

6. The circuit substrate (12; 22; 32; 42) according to any one of the preceding claims, wherein at least one otherwise closed delimiting surface (36) of the hollow space (35) is provided with at least one opening (36a) for the emission of maximum frequency signals.

7. The circuit substrate (12; 22; 32; 42) according to any one of the preceding claims, wherein all delimiting surfaces are substantially completely covered with a metal layer (16; 26; 36; 46).

8. The circuit substrate (12; 22; 32; 42) according to claim 7, wherein the metal layer is removed around a penetration point of a metal feed line, or each metal feed line, projecting into the hollow space (15; 25), in such a way that the feed line, or each feed line (17; 27) is electrically insulated with respect to the metal layer (16; 26).

9. The circuit substrate (12; 22; 32; 42) according to any one of the preceding claims, wherein the metal layer (16; 26; 36; 46) comprises silver or gold or an alloy thereof, at least on the surface facing the hollow space (15; 25; 35; 45).

10. The circuit substrate (12; 22; 32; 42) according to any one of the preceding claims, wherein the metal layer (16; 26; 36; 46) has copper on a surface facing the substrate material.

11. The circuit substrate (22; 32) according to any one of the preceding claims, with at least one other structured metal layer (28; 38.2), in particular in the form of a covering layer of the substrate.

12. The circuit substrate (22; 32) according to claim 11, wherein the other metal layer (28; 38.2) arranged in the form of a covering layer covers at least one portion of the, or each, hollow space (25; 35) acting as a waveguide (25/26; 35/36).

## Revendications

1. Substrat de circuit (12 ; 22 ; 32 ; 42) d'un composant de haute fréquence électronique (10 ; 20 ; 30 ; 40), présentant
une matière de substrat (14 ; 24 ; 34 ; 44) organique,
un constituant de composant (13 ; 23 ; 43) actif, et
au moins une cavité (15) incorporée dans la matière de substrat, munie au moins partiellement d'une couche métallique (16) au niveau des surfaces de délimitation et fonctionnant comme un conducteur creux (15/16 ; 25/26 ; 35/36 ; 45/46) pour des signaux électriques avec une fréquence porteuse de 10 GHz ou plus, qui est directement limitrophe avec le constituant de composant (13 ; 23 ; 43) actif et est reliée électriquement avec le constituant de composant (13 ; 23 ; 43) actif par celui-ci ou par le biais d'une ligne d'alimentation (17 ; 27 ; 47) métallique sortant de la cavité,
où le substrat présente une construction en plusieurs couches qui comprend au moins deux couches de matière de substrat (34.1 ; 34.2) avec une couche métallique (38.1) structurée entre elles, et **caractérisé en ce**
**qu'**une première couche de matière de substrat est conçue sous forme d'un circuit imprimé à polymère liquide cristallin, un circuit imprimé LCP, (34.1), avec un revêtement de cuivre des deux côtés et une deuxième couche de matière de substrat est conçue sous forme d'un film de polymère liquide cristallin, un film LCP, (34.2), plus mince et ayant un point de fusion inférieur par rapport à la première couche de matière de substrat.

2. Substrat de circuit (12 ; 22 ; 32 ; 42) selon la revendication 1, dans lequel la ligne d'alimentation (17 ; 27 ; 47) est une ligne en bande.

3. Substrat de circuit (12 ; 22 ; 32 ; 42) selon la revendication 1 ou la revendication 2, dans lequel la cavité (15 ; 25 ; 35 ; 45) a une forme rectangulaire dans au moins une section perpendiculaire au plan de substrat, notamment dans deux sections perpendiculaires au plan de substrat et perpendiculaires entre elles.

4. Substrat de circuit (12 ; 22 ; 32 ; 42) selon la revendication 3, dans lequel un premier côté de la section ou de l'au moins une sextion de la cavité (15 ; 25 ; 35 ; 45) a une longueur dans la plage de 1 à 4 mm, notamment de 1,5 à 3 mm, et un deuxième côté de cette section a une longueur entre 1 et 7 mm, notamment entre 2 et 5 mm.

5. Substrat de circuit (12 ; 22 ; 32 ; 42) selon l'une des revendications précédentes, dans lequel la cavité (45) est ouverte au moins à une extrémité (45a), de telle manière qu'elle joue le rôle d'antenne pour des signaux de haute fréquence.

6. Substrat de circuit (12 ; 22 ; 32 ; 42) selon l'une des revendications précédentes, dans lequel au moins un orifice (36a) pour l'émission de signaux de haute fréquence est prévu dans au moins une surface de délimitation (36) de la cavité (35) fermée autrement.

7. Substrat de circuit (12 ; 22 ; 32 ; 42) selon l'une des revendications précédentes, dans lequel toutes les surfaces de délimitation sont essentiellement totalement recouvertes avec une couche métallique (16 ; 26 ; 36 ; 46).

8. Substrat de circuit (12 ; 22 ; 32 ; 42) selon la revendication 7, dans lequel la couche métallique est éloignée de l'équivalent d'un point de rencontre et de fusion d'une ligne ou de chaque ligne d'alimentation métallique allant dans la cavité (15 ; 25), de telle manière que la ligne ou chaque ligne d'alimentation (17 ; 27) est isolée électriquement par rapport à la couche métallique (16 ; 26).

9. Substrat de circuit (12 ; 22 ; 32 ; 42) selon l'une des revendications précédentes, dans lequel la couche métallique (16 ; 26 ; 36 ; 46) présente au moins de l'argent, ou de l'or, ou un alliage de ceux-ci, au niveau de la surface orientée vers la cavité (15 ; 25 ; 35 ; 45).

10. Substrat de circuit (12 ; 22 ; 32 ; 42) selon l'une des revendications précédentes, dans lequel la couche métallique (16 ; 26 ; 36 ; 46) présente du cuivre au niveau de la surface orientée vers la matière de substrat.

11. Substrat de circuit (22 ; 32) selon l'une des revendications précédentes, doté d'au moins une nouvelle couche métallique (28 ; 38.2) structurée, notamment sous forme de couche de couverture du substrat.

12. Substrat de circuit (22 ; 32) selon la revendication 11, dans lequel la nouvelle couche métallique (28 ; 38.2) disposée en tant que couche de couverture recouvre au moins une partie de la cavité ou de chaque cavité (25 ; 35) agissant comme un conducteur creux (25/26 ; 36/36).
